# EUROPEAN PATENT APPLICATION

(11) **EP 3 567 638 A1**
(43) Date of publication of application: **13.11.2019**
(21) Application number: 18189300.9
(22) Date of filing: 16.08.2018
(51) Int. Cl.: H01L 31/048, H01L 31/0216

(54) **CURVED-SURFACE COATED PLATE, PREPARATION METHOD THEREOF AND SOLAR MODULE**

(30) Priority: 08.05.2018 CN 201810434302
(71) Applicant: Beijing Hanergy Solar Power Investment Co., Ltd., 101499 Beijing (CN)
(72) Inventor: WU, Zhenyu, Beijing, Beijing 101499 (CN); WAN, Junpeng, Beijing, Beijing 101499 (CN); TAO, Lisong, Beijing, Beijing 101499 (CN); YAN, Yi, Beijing, Beijing 101499 (CN); YANG, Shizhong, Beijing, Beijing 101499 (CN); FANG, Zhenlei, Beijing, Beijing 101499 (CN)
(74) Representative: D'Halleweyn, Nele Veerle Trees Gertrudis

(57) **Abstract**

A curved-surface coated plate is provided. The curved-surface coated plate includes a curved-surface light-transmitting substrate and a film layer arranged on one side of the curved-surface light-transmitting substrate. The film layer is a full dielectric film and includes a high refractive index material film whose refractive index is higher than that of the curved-surface light-transmitting substrate. A method for preparing the curved-surface coated plate and a solar module including the curved-surface coated plate are also provided.

## Description

### Technical Field

The present disclosure relates to, but is not limited to, the technical field of solar energy, in particular to a curved-surface coated plate, a preparation method thereof and a solar module including the same.

### Background

The solar power generation module may use colored coated glass as a front plate, aiming at improving the heat reflection in the infrared band and achieving low radiation. At present, the film layer of conventional coated glass mainly contains metal layers, and this kind of solar power generation module is mainly used in buildings.

The roofs of some buildings are not flat, for example, many Chinese buildings use traditional ridge roofs, which are more suitable for setting curved-surface solar power generation modules. Therefore, there is a need to develop curved-surface solar power generation modules.

### Summary

The following is an overview of the subject matter described in detail herein. This summary is not intended to limit the protection scope of the claims.

At least one embodiment of the present disclosure provides a curved-surface coated plate including a curved-surface light-transmitting substrate and a film layer arranged on one side of the curved-surface light-transmitting substrate, wherein the film layer is a full dielectric film and includes a high refractive index material film whose refractive index is higher than that of the curved-surface light-transmitting substrate.

In an embodiment of the present disclosure, the film layer may further include a low refractive index material film laminated with the high refractive index material film, and the refractive index of the low refractive index material film is lower than that of the curved-surface light-transmitting substrate.

In an embodiment of the present disclosure, the film layer includes multiple layers of the high refractive index material film and multiple layers of the low refractive index material film, and the multiple layers of the high refractive index material film and the multiple layers of the low refractive index material film are alternately laminated on the curved-surface light-transmitting substrate.

In an embodiment of the present disclosure, the film layer includes three layers of the high refractive index material film and two layers of the low refractive index material film, and the curved-surface light-transmitting substrate is adjacent to the high refractive index material film.

In an embodiment of the present disclosure, the film layer includes five layers of the high refractive index material film and four layers of the low refractive index material film, and the curved-surface light-transmitting substrate is adjacent to the high refractive index material film.

In an embodiment of the present disclosure, the film layer includes four layers of the high refractive index material film and three layers of the low refractive index material film, and the curved-surface light-transmitting substrate is adjacent to the high refractive index material film.

In an embodiment of the present disclosure, the film layer may include a first layer of the high refractive index material film, a low refractive index material film, and a second layer of the high refractive index material film, which are arranged in sequence on one side of the curved-surface light-transmitting substrate.

In an embodiment of the present disclosure, the heat resistance temperature of the high refractive index material film and the low refractive index material film may be not less than 650°C.

In an embodiment of the present disclosure, the refractive index of the high refractive index material film at a wavelength of 550 nm may be in the range of 1.92 to 2.60.

In an embodiment of the present disclosure, the refractive index of the low refractive index material film at a wavelength of 550 nm may be in the range of 1.35 to 1.50.

In an embodiment of the present disclosure, the high refractive index material film may include a lanthanum titanate film, a titanium dioxide film, a trititanium pentoxide film, a niobium pentoxide film, a tantalum pentoxide film, or a zirconium dioxide film, or a composite film formed by at least two of these films.

In an embodiment of the present disclosure, the low refractive index material film may include a silicon dioxide film or a magnesium fluoride film, or a composite film of a silicon dioxide film and a magnesium fluoride film.

In an embodiment of the present disclosure, when the film layer includes multiple layers of high refractive index material films, the materials of the multiple layers of high refractive index material films may be same, or the materials of at least two layers of the high refractive index material films may be different.

In an embodiment of the present disclosure, when the film layer includes multiple layers of low refractive index material films, the materials of the multiple layers of the low refractive index material films may be same, or the materials of at least two layers of the low refractive index material films may be different.

In an embodiment of the present disclosure, the color of the curved-surface coated plate may be blue, purple, golden, yellow, red, clay-colored, gray, orange or green color.

At least one embodiment of the present disclosure provides a method for preparing a curved-surface coated plate, the method includes the following steps:
forming a film layer on a surface of one side of a planar light-transmitting substrate to obtain a planar coated plate; the film layer is a full dielectric film and includes a high refractive index material film whose refractive index is higher than that of the planar light-transmitting substrate;
performing thermal bending treatment on the planar coated plate to obtain a curved-surface coated plate.

In an embodiment of the present disclosure, the step of forming a film layer on a surface of one side of the planar light-transmitting substrate may include:
forming the high refractive index material film and the low refractive index material film laminated on the surface of one side of the planar light-transmitting substrate, wherein the refractive index of the low refractive index material film is lower than that of the planar light-transmitting substrate.

In an embodiment of the present disclosure, the step of forming a film layer on a surface of one side of the planar light-transmitting substrate may include:
forming multiple layers of the high refractive index material film and multiple layers of the low refractive index material film alternately arranged on the surface of one side of the planar light-transmitting substrate, and the planar light-transmitting substrate is adjacent to the high refractive index material film.

In an embodiment of the present disclosure, the high refractive index material film and the low refractive index material film may be formed on the planar light-transmitting substrate by adopting an evaporation coating method or a magnetron sputtering method in a vacuum state.

In an embodiment of the present disclosure, the vacuum degree in the vacuum state may be maintained in the range of 1.0×10⁻⁴ Pa to 1.0×10⁻³ Pa before melting or pre-sputtering the coating material; and when melting or sputtering the coating material, the vacuum degree in the vacuum state may be maintained in the range of 3.0×10⁻² Pa to 8.0×10⁻² Pa.

In an embodiment of the present disclosure, the temperature of the thermal bending treatment may be in the range of 650°C to 750°C, and the time may be not less than 20 minutes.

At least one embodiment of the present disclosure provides a solar module, and a front plate of the solar module includes a curved-surface coated plate provided according to any embodiment of the present disclosure.

In an embodiment of the present disclosure, the solar module may further include an adhesive film, a solar cell, and a back plate arranged in sequence on one side of the front plate.

In an embodiment of the present disclosure, the solar module may further include an adhesive film, a solar cell, an adhesive film, and a back plate arranged in sequence on one side of the front plate.

Other features and advantages of the present disclosure will be set forth in the following description and, in part, will become more apparent from the description, or may be learned by carrying out the present disclosure. The objects and other advantages of the present disclosure may be realized and attained by the structure particularly pointed out in the specification, claims, and drawings.

### Brief Description of Drawings

The accompanying drawings are used to provide a further understanding of the technical solution of the present disclosure and form a part of the specification, and together with the embodiments of the present disclosure, are served to explain the technical solution of the present disclosure and do not constitute a limitation on the technical solution of the present disclosure.
FIG. 1 is a comparative curve graph of transmittance of conventional low-radiation coated glass and uncoated blank glass;
FIG. 2 is a curve graph of transmittance of a curved-surface coated plate according to an embodiment of the present disclosure;
FIG. 3 is a curve graph of transmittance of a curved-surface coated plate according to an embodiment of the present disclosure;
FIG. 4 is a curve graph of transmittance of a curved-surface coated plate according to an embodiment of the present disclosure;
FIG. 5 is a curve graph of transmittance of a curved-surface coated plate according to an embodiment of the present disclosure;
FIG. 6 is a curve graph of transmittance of a curved-surface coated plate according to an embodiment of the present disclosure;
FIG. 7 is a process flow chart for preparing a curved-surface coated plate according to an embodiment of the present disclosure;
FIG. 8 is a schematic diagram of a structure of a solar module according to an embodiment of the present disclosure;
FIG. 9 is a schematic diagram of a structure of a solar module according to another embodiment of the present disclosure.

### Detailed Description

Examples of the present disclosure will be described in detail below with reference to the accompanying drawings in order to make the objects, technical solutions and advantages of the present disclosure more clearly understood. It should be illustrated that, if without conflict, the examples and features in the examples of the present disclosure may be combined with each other arbitrarily.

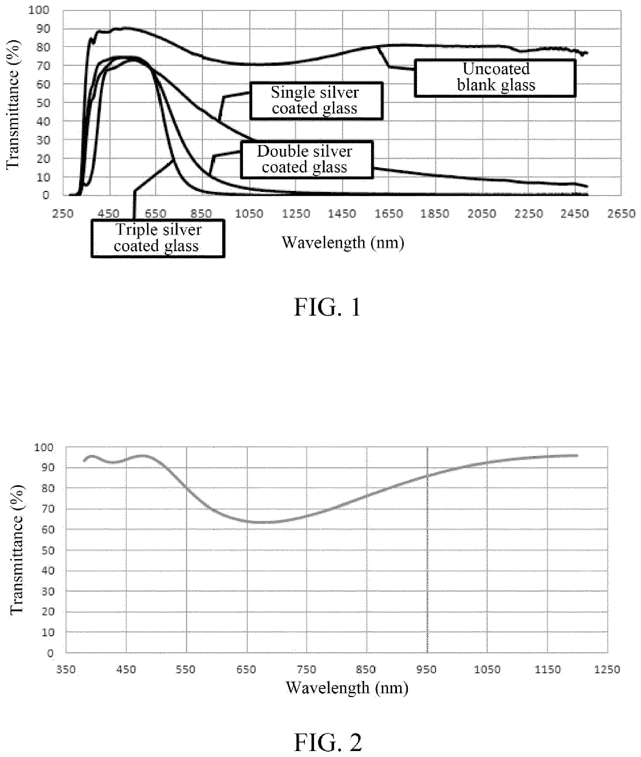

The film layer of conventional coated glass mainly contains metal layer, and the film forming process mainly adopts magnetron sputtering method. Both thermal-reflective coated glass and low-radiation coated glass are common front plate coated glass in solar module. Thermal-reflective coated glass, also known as a solar-controlled coated glass, is a product formed by plating a layer of metal or metal compound composite film on the surface of the glass, an ideal sun-shading effect is achieved and the required reflective color is generated by controlling the sunlight transmittance as required, thus realizing high reflection and low transmittance in the infrared band. Low-radiation coated glass, also known as Low-E glass, is formed by plating a layer of thin film of a metal or compound composite with low emissivity function on the surface of the glass, making the surface of the glass have extremely high far infrared reflectivity, thus achieving the purpose of heat preservation. At present, the common low-radiation coated glasses include: single silver low-radiation coated glass, double silver low-radiation coated glass and triple silver low-radiation coated glass. FIG. 1 is a comparative curve graph of transmittance of single silver low-radiation coated glass, double silver low-radiation coated glass, triple silver low-radiation coated glass, and uncoated blank glass.

At present, there are few curved-surface solar power generation modules and curved-surface coated plate front plates developed. This is because: on the one hand, it is difficult to directly coat a film on a curved-surface substrate, and the film thickness distribution in the entire substrate is difficult to adjust evenly and the cost is high, on the other hand, if a planar substrate is coated with a film and then bent into a curved-surface shape, the film will fall off to a certain extent due to problems such as temperature resistance of the film layer, and even the film layer will break up or completely fall off. In addition, the conventional color coated glass is mainly used in the field of building energy conservation, it mainly reflects infrared light, and the infrared band (780-1100 nm) shows high reflection and low transmittance. However, in the power generation wavelength range of solar module, for example, in the 380 nm to 1100 nm power generation wavelength range of copper indium gallium selenide (CuInₓGa₍₁₋ₓ₎Se₂, CIGS) thin film solar cells and crystalline silicon solar cells, it can be seen from FIG. 1 that the average transmittance of the conventional color coated glass is low, which is not conducive to the power generation of solar power generation modules. Moreover, the film system structure contains a metal film layer. The cost of the metal film layer itself is high, and the metal film layer is unstable and easily oxidized, so it is necessary to make a metal protective layer to prevent the metal film layer from being oxidized, which greatly increases the production cost. In addition, the photovoltaic modules currently used in buildings are mainly black, which is not beautiful enough. Photovoltaic modules in other colors have high sunlight reflectivity and low sunlight transmittance, resulting in poor solar power generation effect.

Embodiments of the present disclosure provide a curved-surface coated plate which can resist high temperature, has an intact film layer, and has a high average transmittance in the power generation wavelength range of solar module, thereby improving the power generation effect of solar module and having a good color effect. Solar module prepared by using the curved-surface coated plate as a front plate has a better power generation effect.

An embodiment of the present disclosure provides a curved-surface coated plate, which includes a curved-surface light-transmitting substrate and a film layer arranged on one side of the curved-surface light-transmitting substrate, wherein the film layer is a full dielectric film and includes a high refractive index material film whose refractive index is higher than that of the curved-surface light-transmitting substrate.

The film layer may also include a low refractive index material film laminated with the high refractive index material film, and the refractive index of the low refractive index material film is lower than that of the curved-surface light-transmitting substrate.

The film layer may include multiple layers of the high refractive index material film and multiple layers of the low refractive index material film, and the multiple layers of the high refractive index material film and the multiple layers of the low refractive index material film are alternately laminated on the curved-surface light-transmitting substrate.

The curved-surface coated plate may include a curved-surface light-transmitting substrate, a high refractive index material film, a low refractive index material film, a high refractive index material film, a low refractive index material film, and a high refractive index material film which are laminated in sequence.

The curved-surface coated plate may include a curved-surface light-transmitting substrate, a high refractive index material film, a low refractive index material film, a high refractive index material film, a low refractive index material film, a high refractive index material film, a low refractive index material film, a high refractive index material film, a low refractive index material film, and a high refractive index material film which are laminated in sequence.

The curved-surface coated plate may include a curved-surface light-transmitting substrate, a high refractive index material film, a low refractive index material film, and a high refractive index material film which are laminated in sequence.

The curved-surface coated plate may include a curved-surface light-transmitting substrate and a high refractive index material film which are laminated in sequence.

The curved-surface coated plate may include a curved-surface light-transmitting substrate, a high refractive index material film, a low refractive index material film, a high refractive index material film, a low refractive index material film, a high refractive index material film, a low refractive index material film, and a high refractive index material film which are laminated in sequence.

The curved-surface coated plate may include a curved-surface light-transmitting substrate, a low refractive index material film, and a high refractive index material film which are laminated in sequence.

What is directly laminated above the curved-surface light-transmitting substrate may be either a high refractive index material film or a low refractive index material film.

The heat resistance temperature of the high refractive index material and the low refractive index material may be not less than the temperature of 650°C, and the heat resistance temperature of the high refractive index material and the low refractive index material may be the temperature of 750°C; the temperature that the high refractive index material and the low refractive index material can bear determines whether the film layer formed by the high refractive index material and the low refractive index material can be kept intact in the subsequent heat treatment process. If the thermal bending treatment is carried out at 650°C in the present disclosure, it is required that the high refractive index material and the low refractive index material can resist the temperature of 650°C; and if the thermal bending treatment is carried out at 750°C in the present disclosure, it is required that the high refractive index material and the low refractive index material can resist the temperature of 750 °C.

The refractive index of the high refractive index material film at a wavelength of 550 nm may be 1.92 to 2.60. By using such a high refractive index material film, the average transmittance of the curved-surface coated plate in the power generation wavelength range of the solar module can be improved to a greater extent, thereby improving the power generation effect of the solar module prepared by using the curved-surface coated plate.

The high refractive index material film may include a lanthanum titanate film, a titanium dioxide film, a trititanium pentoxide film, a niobium pentoxide film, a tantalum pentoxide film, or a zirconium dioxide film, or a composite film formed by at least two of these films. When the high refractive index material film includes any one of a lanthanum titanate film, a titanium dioxide film, a trititanium pentoxide film, a niobium pentoxide film, a tantalum pentoxide film and a zirconium dioxide film, the formed high refractive index material film can be kept intact in the subsequent heat treatment process, and the average transmittance of the curved-surface coated plate in the power generation wavelength range of the solar module can be improved to a greater extent, thereby improving the power generation effect of the solar module prepared by using the curved-surface coated plate.

The refractive index of the low refractive index material film at a wavelength of 550 nm may be 1.35 to 1.50. By using such a low refractive index material film, the average transmittance of the curved-surface coated plate in the power generation wavelength range of the solar module can be improved to a greater extent, thereby improving the power generation effect of the solar module prepared by using the curved-surface coated plate.

The low refractive index material film may include a silicon dioxide film or a magnesium fluoride film, or a composite film of the silicon dioxide film and the magnesium fluoride film. When the low refractive index material film is silicon dioxide or magnesium fluoride, the formed low refractive index material film can be kept intact in the subsequent heat treatment process, and the average transmittance of the curved-surface coated plate in the power generation wavelength range of the solar module can be improved to a greater extent, thereby improving the power generation effect of the solar module prepared by using the curved-surface coated plate.

When the film layer includes multiple layers of high refractive index material films, the multiple layers of high refractive index material films may or may not be exactly the same.

When the film layer includes multiple layers of low refractive index material films, the multiple layers of low refractive index material films may or may not be exactly the same.

The differences between the multiple layers of high refractive index material films or between the multiple layers of low refractive index material films may include, but are not limited to, differences in properties such as material, thickness, shape, area, etc.

The curved-surface coated plate may be colorful, i.e. colored. According to different designs of the film layer, the color of the curved-surface coated plate may be blue, purple, golden, yellow, red, clay-colored, gray, orange or green color, etc. Therefore, the curved-surface coated plate of the embodiment of the present disclosure may be made into different colors as required on the premise of having higher average transmittance in the power generation wavelength range of the solar module, which meets rich and various color requirements, is more beautiful after being combined with buildings, and enables the curved-surface coated plate of the embodiment of the present disclosure to be applicable to a cover plate with decorative effect requirements.

The film system design structure of the curved-surface coated plate may be designed by using a film system design software (for example, Essential Macleod, TFCacl or OptiLayer and other film system design softwares) according to the desired color of the curved-surface coated plate. The film system design can optimize the structure of the coated plate, select a film system structure that can bear the high temperature in the subsequent heat treatment process so as to keep the film layer intact, and also select a film system design structure with lower cost and simpler preparation process under the condition of meeting the requirements of different colors.

Some embodiments of curved-surface coated plates are listed below, wherein H represents a high refractive index material, L represents a low refractive index material such as SiO₂, Sub represents a light-transmitting substrate such as ultra-white float glass, Air represents air, and Air/Sub represents the side of the light-transmitting substrate that is not in contact with the film layer is directly in contact with air. H(1) represents that the first layer on the light-transmitting substrate is a high refractive index material, L(2) represents that the second layer is a low refractive index material, and so on. "Air/Sub/H(1)/L(2)/H(3)/L(4)/H(5)/Air" represents that the coated plate only includes a light-transmitting substrate, a first layer of high refractive index material film, a second layer of low refractive index material film, a third layer of high refractive index material film, a fourth layer of low refractive index material film which are arranged in sequence, and so on.

An embodiment of the present disclosure provides an orange curved-surface coated plate, which may include five layers of full dielectric film, and the film system design structure may be as follows:
Air/Sub/H(1)/L(2)/H(3)/L(4)/H(5)/Air;

The thickness of H(1) is 91.42 nm ±20 nm, the thickness of L(2) is 43.67 nm ±20 nm, the thickness of H(3) is 43.85 nm ±20 nm, the thickness of L(4) is 19.97 nm ±20 nm, and the thickness of H(5) is 27.53 nm ±20 nm;
H may be ZrO₂, Nb₂O₅, Ti₃O₅ or Ta₂O₅.

The transmittance curve of the orange curved-surface coated plate is shown in FIG. 2.

An embodiment of the present disclosure provides a green curved-surface coated plate, which may include nine layers of full dielectric film, and the film system design structure may be as follows:
Air/Sub/H(1)/L(2)/H(3)/L(4)/H(5)/L(6)/H(7)/L(8)/H(9)/Air;

The thickness of H(1) is 54.63 nm ±20 nm, the thickness of L(2) is 12.36 nm ±20 nm, the thickness of H(3) is 38.39 nm ±20 nm, the thickness of L(4)is 35.92 nm ±20 nm, the thickness of H(5) is 51.45 nm ±20 nm, the thickness of L(6) is 31.36 nm ±20 nm, the thickness of H (7) is 45.53 nm ±20 nm, the thickness of L (8) is 33.32 nm ±20 nm, and the thickness of H (9) is 23.29 nm ±20 nm.

H may be ZrO₂, Nb₂O₅, Ti₃O₅ or Ta₂O₅.

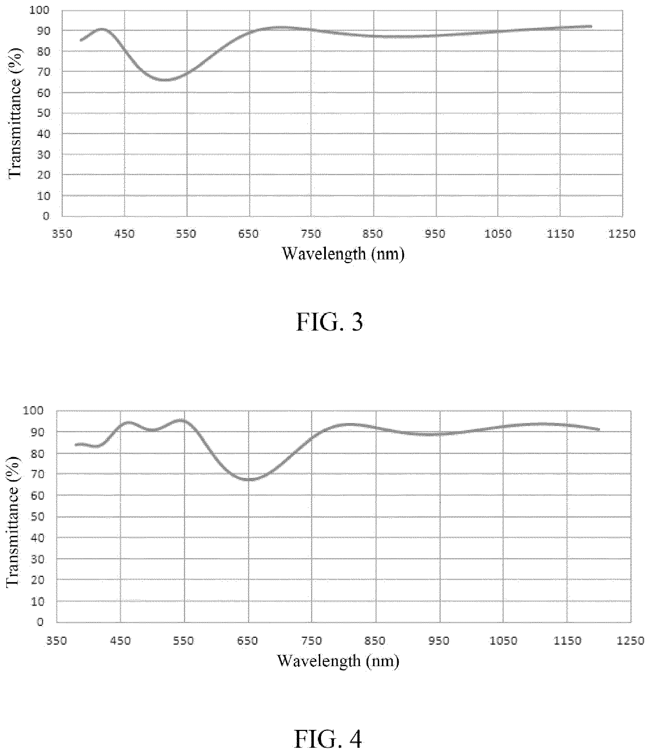

The transmittance curve of the green curved-surface coated plate is shown in FIG. 3.

An embodiment of the present disclosure provides a clay-colored curved-surface coated plate, which may include three layers of full dielectric film, and the film system design structure may be as follows:
Air/Sub/H(1)/L(2)/H(3)/Air;

The thickness of H(1) is 233.30 nm ±20 nm, the thickness of L(2) is 332.52 nm ±20 nm, and the thickness of H(3) is 92.10 nm ±20 nm;
H may be ZrO₂, Nb₂O₅, Ti₃O₅ or Ta₂O₅.

The transmittance curve of the clay-colored curved-surface coated plate is shown in FIG. 4.

An embodiment of the present disclosure provides a gray curved-surface coated plate, which may include one layer of full dielectric film, and the film system design structure may be as follows:
Air/Sub/H(1)/Air;
The thickness of H(1) is 26.00 nm ±20 nm;
H may be ZrO₂, Nb₂O₅, Ti₃O₅ or Ta₂O₅.

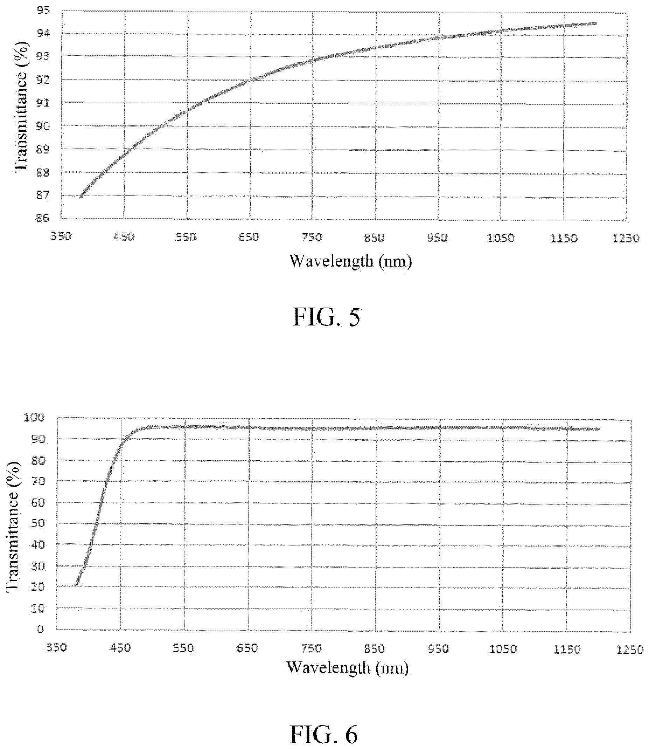

The transmittance curve of the gray curved-surface coated plate is shown in FIG. 5.

An embodiment of the present disclosure provides a purple curved-surface coated plate, which may include seven layers of full dielectric film, and the film system design structure may be as follows:
Air/Sub/H(1)/L(2)/H(3)/L(4)/H(5)/L(6)/H(7)/Air;

The thickness of H(1) is 17.38 nm ±20 nm, the thickness of L(2) is 61.14 nm ±20 nm, the thickness of H(3) is 34.78 nm ±20 nm, the thickness of L(4) is 61.14 nm ±20 nm, the thickness of H(5) is 34.78 nm ±20 nm, the thickness of L(6) is 61.14 nm ±20 nm, and the thickness of H (7) is 17.38 nm ±20 nm;
H may be ZrO₂, Nb₂O₅, Ti₃O₅ or Ta₂O₅.

The transmittance curve of the purple curved-surface coated plate is shown in FIG. 6.

As can be seen from FIGS. 2-6, although the transmittance of the colored curved-surface coated plate of the embodiment of the present disclosure is low in the visible light region, the transmittance is high in the infrared light region, therefore the average transmittance is high in the power generation wavelength range of solar module, especially in the 380 nm to 1100 nm wavelength range. It can be used as the front plate of colored solar module, which can achieve a better power generation effect.

The curved-surface coated plate of the embodiment of the present disclosure can be made into different colors as required so as to meet the requirements of rich and various colors, and is more beautiful after being combined with buildings.

In addition, it should be understood that using the same high refractive index material and low refractive index material, curved-surface coated plates with the same colors can also be made by increasing or decreasing the layer number of the coated film and adjusting the thickness of each layer of film, such as increasing or decreasing the thickness of the thin film. Moreover, upon detection, the spectrum of curved-surface coated plates of the same color prepared by using different film system design structures is almost the same. However, when designing the film system, a smaller layer number of the film should be used as few as possible in order to reduce the cost.

An embodiment of the present disclosure provides a method for preparing the curved-surface coated plate as described above, which includes the following steps:
forming a film layer on a surface of one side of a planar light-transmitting substrate to obtain a planar coated plate; the film layer is a full dielectric film and includes a high refractive index material film whose refractive index is higher than that of the planar light-transmitting substrate;
performing thermal bending treatment on the planar coated plate to obtain a curved-surface coated plate;
wherein the refractive index of the planar light-transmitting substrate is unchanged before and after bending deformation.

The step of forming a film layer on a surface of one side of a planar light-transmitting substrate may include:
forming, on the surface of one side of the planar light-transmitting substrate, a high refractive index material film and a low refractive index material film which are laminated, and the refractive index of the low refractive index material film being lower than that of the planar light-transmitting substrate.

The step of forming a film layer on a surface of one side of a planar light-transmitting substrate may include:
forming, on the surface of one side of the planar light-transmitting substrate, multiple layers of high refractive index material films and multiple layers of low refractive index material films which are alternately arranged, the planar light-transmitting substrate being adjacent to the high refractive index material film.

The high refractive index material film and the low refractive index material film are formed on a planar light-transmitting substrate by adopting an evaporation coating method or a magnetron sputtering method in a vacuum state.

The vacuum coating method may be an evaporation coating method or a magnetron sputtering method. The evaporation coating method may be an electron gun evaporation coating method, and may use a vacuum coating method in the optical field to form a film on the optical glass, to deposit at least one layer of high refractive index material film and optionally at least one layer of low refractive index material film on the surface of the planar light-transmitting substrate of the present disclosure. For example, a vacuum coating method of coating on the optical glass of the camera lens is used.

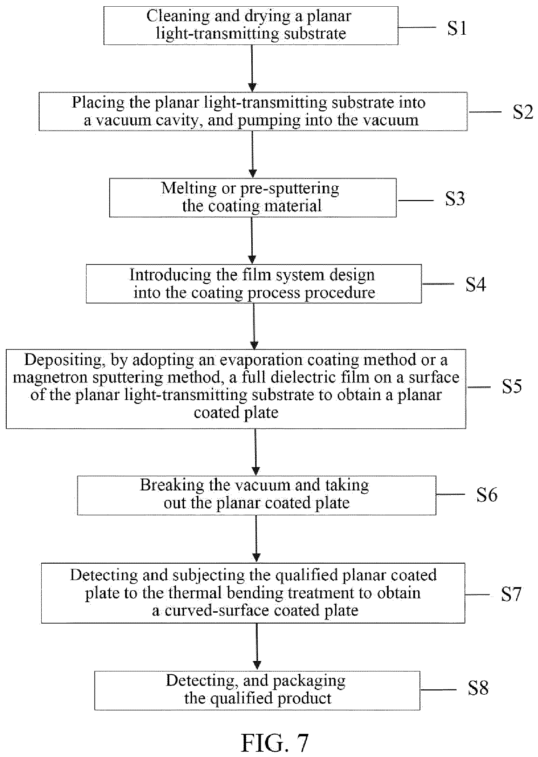

As shown in FIG. 7, in an exemplary embodiment, the method may include the following steps:
S1: Cleaning and drying a planar light-transmitting substrate;
S2: Placing the dried planar light-transmitting substrate into a vacuum cavity of a coating equipment, and pumping the vacuum cavity into a vacuum state;
S3: Melting or pre-sputtering the coating material;
S4: Introducing the film system design into the coating process procedure;
S5: Depositing the melted or pre-sputtered coating material on a surface of the planar light-transmitting substrate by adopting an evaporation coating method or a magnetron sputtering method to form at least one layer of high refractive index material film and optionally at least one layer of low refractive index material film to obtain a planar coated plate;
S6: Breaking the vacuum and taking out the planar coated plate;
S7: Detecting the planar coated plate, and turning the qualified planar coated plate into a heat treatment equipment; performing thermal bending or steel bending treatment on the qualified planar coated plate to obtain a curved-surface coated plate;
S8: Detecting the curved-surface coated plate, and packaging the qualified product.

The vacuum degree in the vacuum cavity may be maintained in the range of 1.0×10⁻⁴ Pa to 1.0×10⁻³ Pa before melting or pre-sputtering the coating material; when depositing a high refractive index material film or a low refractive index material film, the vacuum degree in the vacuum cavity may be maintained in the range of 3.0×10⁻² Pa to 8.0×10⁻² Pa. When depositing a high refractive index material film or a low refractive index material film in the present disclosure, the vacuum degree in the vacuum cavity is controlled within the range of 3.0×10⁻² Pa to 8.0×10⁻² Pa, so that a film layer with high purity and appropriate hardness can be more easily obtained.

The temperature of the thermal bending treatment may be 650°C to 750°C, and the time may be not less than 20 minutes.

The planar light-transmitting substrate may be a planar glass substrate or a planar light-transmitting polymer material substrate.

The planar glass substrate may be a light-transmitting glass such as planar ultra-white float glass, planar ordinary float glass, colored planar original glass, or planar optical glass.

The planar light-transmitting polymer material substrate may be a planar light-transmitting resin substrate.

The planar light-transmitting resin substrate may be a light-transmitting substrate such as planar polycarbonate (PC) substrate or polymethyl methacrylate (PMMA) substrate.

The curved-surface coated plate of the embodiment of the present disclosure adopts a full dielectric film, and by optimizing the selection of coating materials and adjusting the film system structure, the film layer can bear the high temperature in the subsequent heat treatment process, for example, the high temperature of 650°C; after heat treatment, the film layer can be kept intact, so that the coated planar substrate can be thermally treated into various curved-surface shapes according to the needs of use occasions. In addition, the material film in the curved-surface coated plate of the embodiment of the present disclosure adopts a full dielectric film. By increasing the transmittance of the curved-surface coated plate in the infrared band, the average transmittance of the curved-surface coated plate in the power generation wavelength range of solar module, especially in the band of 380 nm to 1100 nm, is increased, thereby significantly improving the power generation efficiency of the solar module prepared by the curved-surface coated plate. In addition, because the curved-surface coated plate of the embodiment of the present disclosure does not adopt the metal film layer, the problem that the metal film layer is oxidized is avoided, and the metal protective layer is not required to be arranged, thus saving the cost.

An embodiment of the present disclosure provides a solar module, which may adopt the curved-surface coated plate provided by any embodiment of the present disclosure as a front plate. As the average transmittance of the curved-surface coated plate provided by the embodiment of the present disclosure is higher in the power generation wavelength range of solar module, the power generation effect of solar module is better.

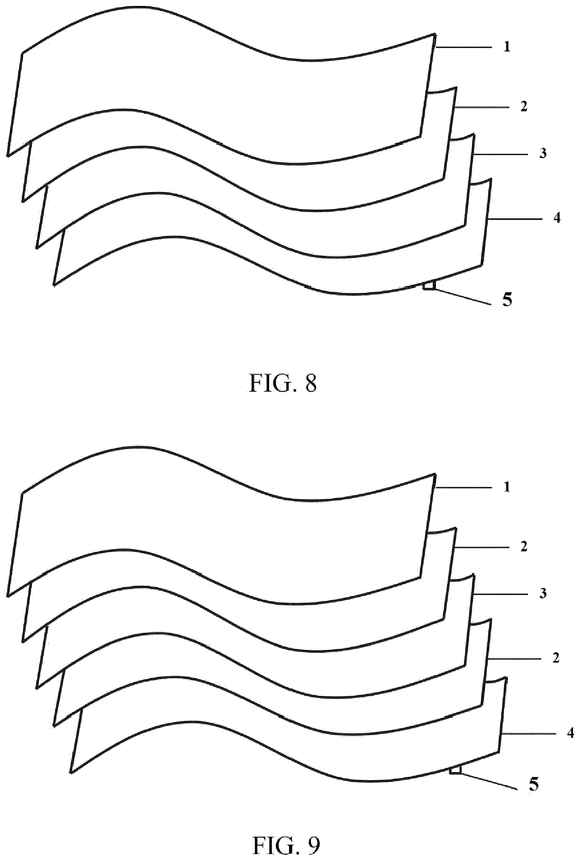

As shown in FIG. 8, the solar module may include a front plate 1, an adhesive film 2, a solar cell 3 and a back plate 4 which are arranged in sequence, and a junction box 5 electrically connected to the solar cell 3 is arranged below or at one side of the back plate 4. The front plate 1 is a curved-surface coated plate provided by the embodiment of the present disclosure.

As shown in FIG. 9, the solar module may include a front plate 1, an adhesive film 2, a solar cell 3, an adhesive film 2 and a back plate 4 which are arranged in sequence, and a junction box 5 electrically connected with the solar cell 3 is arranged below or at one side of the back plate 4. The front plate 1 is a curved-surface coated plate provided by the embodiment of the disclosure.

The adhesive film therein may be formed of a polymer material having viscosity, for example, polyvinyl butyral (PVB) or ethylene vinyl acetate (EVA).

The solar cell may be various types of flexible thin film solar cells or flexible crystalline silicon solar cells, for example, flexible copper indium gallium selenium (CuInₓGa₍₁₋ₓ₎Se₂, CIGS) thin film solar cells.

It should be understood that the solar module of the embodiment of the present disclosure can be prepared by methods commonly used in the art to prepare a solar module.

Therefore, the specific structure, adhesive film and type of solar cell of the solar module of the present disclosure can be selected as required, so that the solar module of the present disclosure can be used in more occasions. Since the average transmittance of the front plate of the curved-surface coated plate of the present disclosure is especially high in the power generation wavelength range of 380 nm to 1100 nm of the CIGS thin film solar cell or the crystalline silicon solar cell, the power generation effect of the solar module is better when the solar cell adopts the CIGS thin film solar cell or the crystalline silicon solar cell.

Moreover, in addition to being applied to buildings, the curved-surface coated plate of the embodiment of the present disclosure may also be applied to a cover plate with decorative effect requirements, such as cell phone back plates, refrigerator panels, and the like.

This disclosure is illustrative of the principles of examples of the present disclosure and is not intended to limit the application in any form or substance, or to limit the application to particular embodiments. It will be apparent to those skilled in the art that variations, changes, modifications, evolutions, and the like may be made to the elements, methods, and systems of the technical solutions of the examples of the present disclosure without departing from the principles, spirit, and scope of the examples, technical solutions of the present disclosure. Embodiments of such variations, changes, modifications, and evolutions are all included within equivalent examples of the present disclosure. Although the examples of the present disclosure may be embodied in many different forms, what is described in detail herein are merely some embodiments of the invention. Furthermore, examples of the present disclosure include any possible combination of some or all of the various embodiments described herein. All patents, patent applications, and other cited materials mentioned in this application or anywhere in any cited patent, cited patent application, or other cited material are hereby incorporated by reference in their entirety.

The above disclosure is intended to be illustrative and not exhaustive. Many variations and alternatives will be suggested to those skilled in the art. The term "including" means "including, but not limited to".

A description of alternative exemplary embodiments of the present disclosure has been completed herein.

## Claims

1. A curved-surface coated plate comprising a curved-surface light-transmitting substrate and a film layer arranged on one side of the curved-surface light-transmitting substrate, wherein the film layer is a full dielectric film and comprises a high refractive index material film whose refractive index is higher than that of the curved-surface light-transmitting substrate.

2. The curved-surface coated plate according to claim 1, wherein the film layer further comprises a low refractive index material film laminated with the high refractive index material film, and the refractive index of the low refractive index material film is lower than that of the curved-surface light-transmitting substrate.

3. The curved-surface coated plate according to claim 2, wherein the film layer comprises multiple layers of the high refractive index material film and multiple layers of the low refractive index material film, and the multiple layers of the high refractive index material film and the multiple layers of the low refractive index material film are alternately laminated on the curved-surface light-transmitting substrate.

4. The curved-surface coated plate according to claim 3, wherein
the film layer comprises three layers of the high refractive index material film and two layers of the low refractive index material film, and the curved-surface light-transmitting substrate is adjacent to the high refractive index material film; or
the film layer comprises five layers of the high refractive index material film and four layers of the low refractive index material film, and the curved-surface light-transmitting substrate is adjacent to the high refractive index material film; or
the film layer comprises four layers of the high refractive index material film and three layers of the low refractive index material film, and the curved-surface light-transmitting substrate is adjacent to the high refractive index material film.

5. The curved-surface coated plate according to claim 2, wherein the film layer comprises a first layer of the high refractive index material film, a low refractive index material film and a second layer of the high refractive index material film, which are arranged in sequence on one side of the curved-surface light-transmitting substrate.

6. The curved-surface coated plate according to any one of claims 1-5, wherein the refractive index of the high refractive index material film at a wavelength of 550 nm is in the range of 1.92 to 2.60.

7. The curved-surface coated plate according to any one of claims 2-5, wherein the refractive index of the low refractive index material film at a wavelength of 550 nm is in the range of 1.35 to 1.50.

8. A method for preparing a curved-surface coated plate, the method comprising:
forming a film layer on a surface of one side of a planar light-transmitting substrate to obtain a planar coated plate; the film layer is a full dielectric film and comprises a high refractive index material film whose refractive index is higher than that of the planar light-transmitting substrate; and
performing thermal bending treatment on the planar coated plate to obtain a curved-surface coated plate.

9. The method according to claim 8, wherein the step of forming a film layer on a surface of one side of the planar light-transmitting substrate comprises:
forming, on the surface of one side of the planar light-transmitting substrate, the high refractive index material film and the low refractive index material film which are laminated, and the refractive index of the low refractive index material film being lower than that of the planar light-transmitting substrate.

10. The method according to claim 8, wherein the step of forming a film layer on a surface of one side of the planar light-transmitting substrate comprises:
forming, on the surface of one side of the planar light-transmitting substrate, multiple layers of the high refractive index material film and multiple layers of the low refractive index material film which are alternately arranged, and the planar light-transmitting substrate being adjacent to the high refractive index material film.

11. The method according to claim 9 or 10, wherein the high refractive index material film and the low refractive index material film are formed on the planar light-transmitting substrate by adopting an evaporation coating method or a magnetron sputtering method in a vacuum state.

12. The method according to claim 11, wherein the vacuum degree in the vacuum state is maintained in the range of 1.0×10⁻⁴ Pa to 1.0×10⁻³ Pa before melting or pre-sputtering the coating material; and when melting or sputtering the coating material, the vacuum degree in the vacuum state is maintained in the range of 3.0×10⁻² Pa to 8.0×10⁻² Pa.

13. The method according to any one of claims 8-12, wherein the temperature of the thermal bending treatment is in the range of 650°C to 750°C, and the time is not less than 20 minutes.

14. A solar module, wherein a front plate (1) of the solar module comprises the curved-surface coated plate according to any one of claims 1-7.

15. The solar module according to claim 14, wherein the solar module further comprises an adhesive film (2), a solar cell (3), and a back plate (4) arranged in sequence on one side of the front plate (1); or
the solar module further comprises an adhesive film (2), a solar cell (3), an adhesive film (2) and a back plate (4) arranged in sequence on one side of the front plate (1).
